# EUROPEAN PATENT SPECIFICATION

(11) **EP 2 934 077 B1**
(45) Date of publication and mention of the grant of the patent: **15.08.2018**
(21) Application number: 12890312.7
(22) Date of filing: 17.12.2012
(51) Int. Cl.: H05K 7/20, H05K 7/18

(54) **HEAT SHUTTER DEVICE**
WÄRMEVERSCHLUSSVORRICHTUNG
DISPOSITIF OBTURATEUR DE CHALEUR

(43) Date of publication of application: 21.10.2015
(73) Proprietor: Hitachi Systems, Ltd., Tokyo 141-8672 (JP)
(72) Inventor: MAEDA, Takahiro, Tokyo 141-8672 (JP)
(74) Representative: Locas, Davide
(86) International application number: PCT/JP2012/082655
(87) International publication number: WO 2014/097367

(56) References cited:
- JP-A- H02 187 984
- JP-A- 2008 117 876
- JP-A- 2008 130 714
- JP-A- 2012 248 565
- US-A1- 2007 173 189
- US-A1- 2009 122 484
- US-A1- 2010 085 726
- US-A1- 2012 112 612

## Description

### TECHNICAL FIELD

The present invention relates to a heat shutter device, and in particular to a technique of preventing a return flow of warm air exhausted from a back face of an electronic device from sneaking to a front face of the electronic device.

### BACKGROUND ART

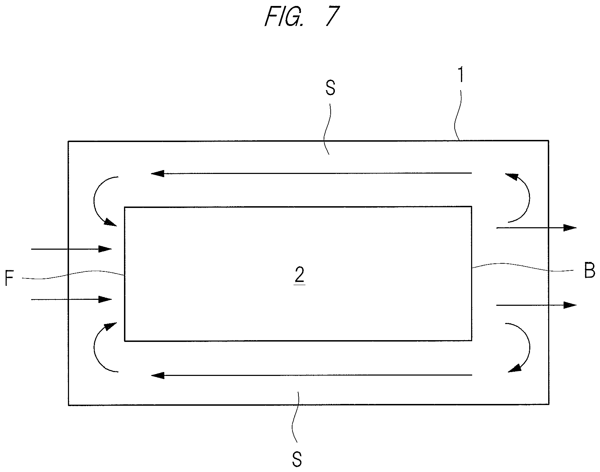

In a data center or the like, electric devices such as a server are mounted in a cabinet-type rack, and cables connected to the electronic devices are collected in a space on a back face side in the rack. In recent years, the number of cables increases due to high density of electronic devices, which makes it impossible to handle the cables. Therefore, in order to make it easy to handle the cables in the rack, a rack 1 having side spaces S secured on both sides of an electronic device 2 by widening a width of the rack 1 itself has been used, for example, as shown in FIG. 7. An electronic device is generally structured to take in air from its front face to cool inside of the electronic device and exhaust warmed air from its back face.

However, in such a rack 1, since such a return flow of warm air exhausted from a back face B of the electronic device 2 and passing through the side spaces S to sneak to a front face F of the electronic device 2 is generated, and an intake air temperature of the electronic device 2 rises due to the return flow, it becomes difficult to cool the electronic device 2 efficiently. Therefore, a temperature abnormality of the electronic device 2 occurs, which may result in such a case that an adverse effect such as a lowering of durability of the electronic device 2 occurs.

Therefore, a rack provided with a heat shutter for preventing a return flow from being generated in a rack has been provided. Incidentally, as the heat shutter, one described in patent document 1 is known.

### RELATED ART DOCUMENTS

### PATENT DOCUMENTS

Patent Document 1: Japanese Patent Application Laid-Open No. 2007-305754

### SUMMARY OF THE INVENTION

### PROBLEMS TO BE SOLVED BY THE INVENTION

However, as the existing heat shutter, there are many ones of a bush type, a gap not only is easily generated due to a handling situation of cables but also many of them cannot be retrofitted. Further, due to such a configuration of the heat shutter described in patent document 1 that since a sheet is attached to an insertion port for cables, and an opening having a size required for insertion of cables is formed in the sheet to insert the cable therein, insertion of the cables is not only troublesome but also the sheet may be broken.

Incidentally, though an electronic device mounted in a rack is generally structured so as to take in air from a front face thereof and exhaust the air from a back face thereof, there is also an electronic device structured so as to perform intake of air and exhaust thereof from side faces of the electronic device, and in such an electronic device, the heat shutter cannot be installed because intake of air and exhaust thereof are prevented.

Therefore, an object of the present invention is to provide a heat shutter device where a return flow prevention measure can be easily adopted depending on an installation situation of an electronic device regarding side spaces in a rack.

### MEANS FOR SOLVING THE PROBLEMS

A heat shutter device according to the present invention is a heat shutter device provided in a rack where a plurality of electronic devices are mounted in a height direction thereof while side spaces for cable wirings are secured on both sides of the electronic devices, and the heat shutter device includes: a heat shutter blocking a return flow of warm air, which is exhausted from a back face of the electronic device and passes through the side spaces to sneak to a front face of the electronic device, with respect to each electronic device; a coupling bar provided in the rack in a height direction of the electronic devices via a base portion; and an engagement portion provided on one side of the heat shutter and pivotally engaged with the coupling bar. The heat shutter preferably has an elastic member closing a gap between the heat shutter and the electronic device on a back face of the heat shutter. When the electronic devices include an electronic device having an intake port or an exhaust port at a side face thereof, it is preferable that an intake duct or an exhaust duct communicating with the intake port or the exhaust port is attached to the electronic device having the intake port or the exhaust port at the side face without attaching the heat shutter thereto.

The elastic member is preferably composed of flame-retardant sponge.

The plurality of electronic devices mounted in a height direction thereof include a first electronic device having an intake port on a front face thereof and an exhaust port on a back face thereof, and a second electronic device having an intake port or an exhaust port on a side face thereof, and an intake duct or an exhaust duct having the intake port or the exhaust port and a front face or a back face of the second electronic device communicated with each other is preferably attached to the second electronic device in place of the heat shutter.

### EFFECTS OF THE INVENTION

According to the present invention, it is possible to provide a heat shutter device where a return flow prevention measure depending on an installation situation of an electronic device regarding side spaces in a rack can be adopted easily.

### BRIEF DESCRIPTIONS OF THE DRAWINGS

FIG. 1 is a perspective view showing an attachment state of a heat shutter for a side space according to an embodiment of the present invention;
FIG. 2 is a side view schematically showing a configuration of the heat shutter;
FIG. 3 is a top view of a heat shutter base;
FIG. 4 are views showing the heat shutter, FIG. 4(a) being a front view and
FIG. 4(b) being a side view;
FIG. 5 is a top view showing a state where the heat shutter has been attached to the heat shutter base;
FIG. 6 is a schematic plan sectional view showing an attachment state of the heat shutter; and
FIG. 7 is a schematic plan view showing a flow of cooling air in a conventional server rack.

### DETAILED DESCRIPTION OF PREFERRED EMBODIMENTS

An embodiment for implementing the present invention will be described below with reference to attached drawings.

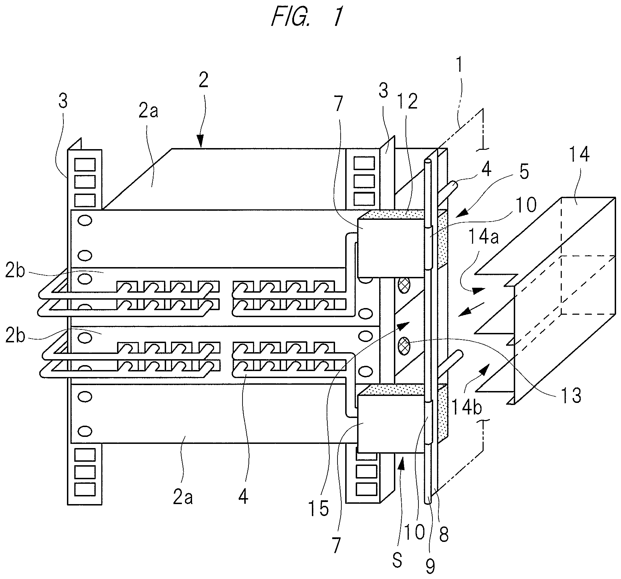

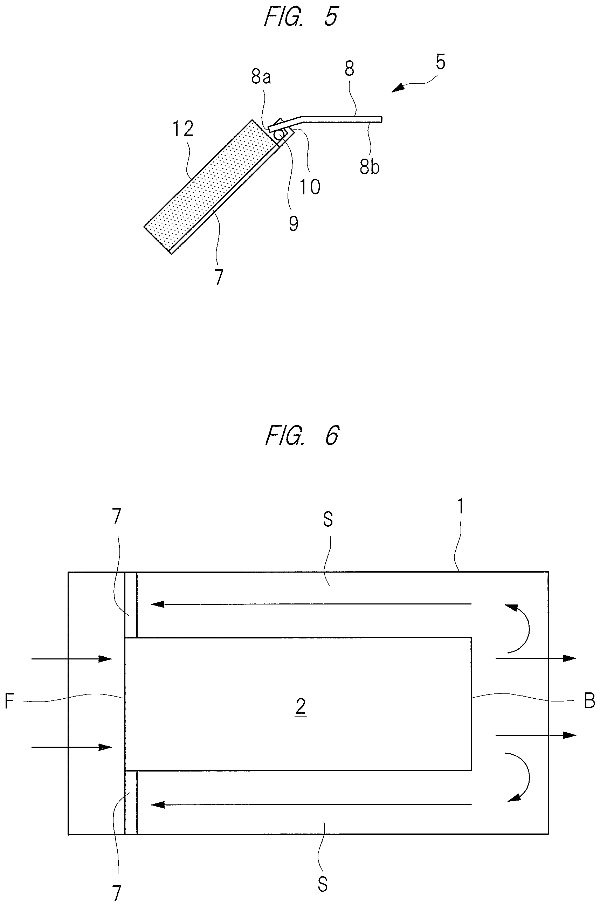

As shown in FIG. 1 or FIG. 6, a plurality of electronic devices 2 such as a server are mounted in a rack 1 of a cabinet type through angles 3 and metal fittings in a height direction. Cables 4 are connected to each electronic device 2 and the cables 4 extend through both sides of the electronic device 2 to be collected in a space on a back face side of the electronic device 2. In order to make it easy to handle cables 4 in the rack 1, side spaces S are provided on both sides of the electronic device 2 in the rack 1.

The electronic device 2 is generally structured to take in air from a front face F thereof and exhaust air warmed inside the electronic device 2 from a back face B thereof in order to relieve generated heat. Therefore, in the electronic device 2, such a return flow of warmed exhaust air (warm air), which is exhausted from the back face B of the electronic device 2, passes through the side spaces S to sneak to the front face F of the electronic device 2 and taken inside the electronic device 2 again, is generated. In order to prevent such a return flow, heat shutter devices 5 are provided in the side spaces S.

The heat shutter devices 5 are arranged on both sides of the front faces F of the electronic devices 2. The heat shutter devices 5 include a plate-like heat shutter 7 (the same meaning as a heat shutter plate) for blocking the return flow of warm air, which is exhausted from the back face B of the electronic device 2 and passes through the side spaces S to sneak to the front face F of the electronic device 2, with respect to each electronic device 2, a coupling bar 9 provided in the rack 1 via a base portion 8 for coupling the heat shutters 7 to one another, and engagement portions 10 provided in the heat shutters 7, detachably engaged with the coupling bar 9 and pivotally supporting the heat shutters 7.

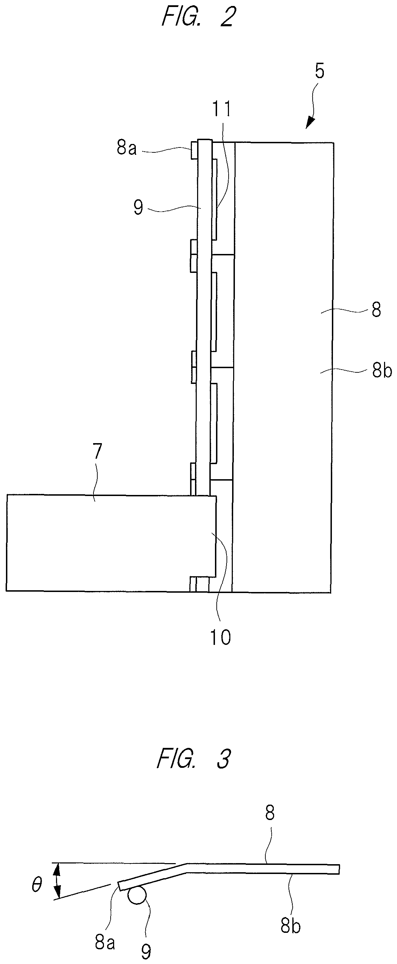

The base portion 8 is formed in a rectangular plate shape vertically elongated and having a plurality of times a height of the electronic device 2 (four times in the example shown in FIG. 2). As a material of the base portion 8, metal is preferable. A base of the base portion 8 is fixed to a frame or a side panel of the rack 1. It is preferable that when the base portion 8 is fixed to the frame of the rack 1, a screw is used as a fixing means, and that when the base portion 8 is fixed to the side panel of the rack 1, a magnet is used as the fixing means.

The coupling bar 9 includes a metal bar shaft that is circular in section, and the coupling bar 9 is provided on an outer face on a distal end portion of the base portion 8 over a whole length of the base portion 8 in a height direction by fixing means such as welding or screwing. It is preferable for the sake of manufacture that the coupling bar 9 is set to have the same height as that of the base portion 8. Incidentally, the coupling bar 9 may be divided to pieces for respective heat shutters 7.

A clearance groove 11 for avoiding buffering with the engagement portion 10 of the heat shutter 7 is formed in the base portion 8. Further, in order to make attachment of the heat shutter 7 easy, it is preferable that the side of a distal end portion 8a of the base portion 8 is bent outward at a predetermined angle θ to the side of a base 8b of the base portion 8, as shown in FIG. 3 or FIG. 5.

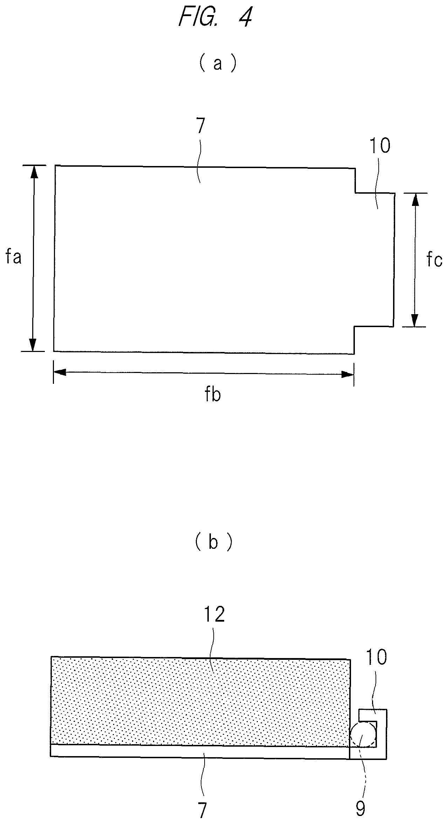

The heat shutter 7 is composed of a metal plate having predetermined vertical width fa and lateral width fb so as to cover the side space S from the front face side of the electronic device 2, as shown in FIGS. 4(a) and 4(b), and FIG. 6. The vertical width fa of the heat shutter 7 is set to have a height of one unit of the electronic devices 2. The lateral width fb of the heat shutter 7 is set to have a width between the electronic devices 2 and the frame or the side panel of the rack 1.

An engagement portion 10 detachably engaged with the coupling bar 9 to pivotally support the heat shutter 7 is provided on one side portion of the heat shutter 7. The engagement portion 10 has a vertical width fc narrower than the vertical width fa of the heat shutter 7, and the engagement portion 10 is bent in a U shape in section so as to surround the periphery of the coupling bar 9 between the same (the engagement portion 10) and an elastic member 12.

The heat shutter 7 has the elastic member 12 closing a gap between the same (the heat shutter 7) and the electronic device 2 in conformity with irregularities of the cables 4 or the like. The elastic member 12 is formed in a block shape or in a rectangular-parallelepiped shape having approximately the same size as a plate-like portion of the heat shutter 7 except for the engagement portion 10 and a predetermined thickness.

In order to close the gap between the heat shutter 7 and the electronic device 2 in conformity with irregularities of the cables 4 or the like and be capable of withstanding heat generated from the electronic device 2, it is preferable that the elastic member 12 is composed of flame-retardant sponge. The elastic member 12 is attached to an inner face of the heat shutter 7 via adhesive or an adhesive sheet.

In the embodiment shown in FIG. 1, the electronic devices 2 stacked in a height direction include a first electronic device 2a having an intake port (not shown) on a front face thereof and an exhaust port (not shown) on a back face thereof, and a second electronic device 2b having an intake port 13 or an exhaust port on a side face thereof. When the second electronic device 2b having an intake port 13 or an exhaust port on a side face is included in this manner, an intake duct 14 or an exhaust duct (not shown) having the intake port 13 or the exhaust port and the front face or the back face of the electronic device 2b communicated with each other is attached to a side face of the second electronic device 2b in the second electronic device 2b in place of the heat shutter 7.

In this case, the intake duct 14 is opened at its inside face 14a and its front end face 14b facing the side wall of the second electronic device 2b, and the exhaust duct is opened at its inside face and its back end face. The intake duct 14 or the exhaust duct is attached in such a state that the front end portion of the intake duct 14 or the back end portion of the exhaust duct is fitted in a square opening portion 15 surrounded by the second electronic device 2b, the base portion 8 and the heat shutters 7.

According to the heat shutter device 5 structured in the above manner, it becomes possible to adopt a return flow prevention measure depending on an installation situation of the electronic devices 2 regarding the side spaces S inside the rack 1, and the heat shutter device 5 that can achieve improvement of durability of the electronic device 2 while suppressing rising of an intake temperature of the electronic device 2 can be provided.

Since the heat shutter 7 is structured so as to be pivotally supported by attaching the elastic member 12, having one unit size of the electronic devices 2 and composed of the flame-retardant sponge, to the back face and hooking the engagement portion 10 on the coupling bar 9 of the base portion 8, an installation angle about the coupling bar 9 of the heat shutter 7 can be adjusted optionally depending on an amount of cables 4 for each unit of the electronic devices 2, and it becomes possible to make a gap between the heat shutter 7 and the electronic device 2 sufficiently small by shrinkage of the elastic member 12 to block a circulation of exhaust air.

Further, since the heat shutter 7 has the engagement portion 10 detachably engaged with the coupling bar 9 to pivotally support the heat shutter 7, attaching and detaching of the heat shutter 7 can be easily performed depending on an installation situation of the electronic device 2, which can result in improvement of workability.

In addition, since the intake duct 14 is structured to take in air from the front face side of the rack 1, the exhaust duct is structured to exhaust air from the back face side of the rack 1, and either one of the intake duct 14 and the exhaust duct can be selected depending on the intake port 13 or the exhaust port arranged on the side face of the electronic device, it becomes possible to cool the electronic device efficiently, thereby achieving achieve improvement of the durability of the electronic device.

### INDUSTRIAL APPLICABILITY

Since the server rack is used not only in the data center but also in a company server room or the like, when a side space is present in the server rack, it becomes necessary to adopt a return flow prevention measurement of warm air in the side space. Thus, the present invention can be utilized effectively. Further, since the present invention can be applied to an electronic device performing intake of air and exhaust of air from a side of a network device or the like by replacing the heat shutter with the intake duct or the exhaust duct, a measure depending on an electronic device to be installed can be adopted, and since it becomes possible to cool an electronic device such as a server housed in a server rack efficiently by prevention of a return flow, an effect of energy saving can be obtained. Thus, the present invention can be utilized effectively.

### Explanation of Reference Signs

- 1: rack
- 2: electronic device
- 2a: first electronic device
- 2b: second electronic device
- 3: angle
- 4: cable
- 5: heat shutter device
- S: side space
- 7: heat shutter
- 8: base portion
- 8a: distal end portion
- 8b: base
- 9: coupling bar
- 10: engagement portion
- 11: clearance groove
- 12: elastic member
- 13: intake port
- 14: intake duct
- 14a: inside face
- 14b: front end face
- 15: opening portion

## Claims

1. A heat shutter device (5) provided in a rack (1) where a plurality of electronic devices (2) are mounted in a height direction thereof while side spaces (S) for cable wirings (4) are secured on both sides of the electronic devices (2), the heat shutter device (5) comprising:
a heat shutter (7) covering the side space (S) for cable wirings (4) from the front side of the electronic device (2) and blocking a return flow of warm air, which is exhausted from a back face (B) of the electronic device and passes through the side spaces (S) for cable wiring (4) to sneak to a front face (F) of the electronic device (2), with respect to each electronic device;
a coupling bar (9) provided in the rack (1) in a height direction of the electronic device via a base portion (8); and
an engagement portion (10) provided on one side of the heat shutter (7) and pivotally engaged with the coupling bar (9).

2. The heat shutter device (5) according to claim 1,
wherein the heat shutter (7) has an elastic member (12) closing a gap between the heat shutter (7) and the electronic device (2) on a back face of the heat shutter (7).

3. The heat shutter device (5) according to claim 2, wherein the elastic member (12) is composed of flame-retardant sponge.

4. The heat shutter device (7) according to claim 1, wherein the plurality of electronic devices (2) mounted in a height direction thereof include:
- a first electronic device (2a) having an intake port on a front face thereof and an exhaust port on a back face thereof, and
- a second electronic device (2b) having an intake port (13) or an exhaust port on a side face thereof,
wherein an intake duct (14) or an exhaust duct, having the intake port or the exhaust port and a front face or a back face of the second electronic device (2b) communicated with each other, is attached to the second electronic device (2b) in place of the heat shutter (7).

## Patentansprüche

1. Wärmerolladenvorrichtung (5), die in einem Rack (1) vorgesehen ist, wobei eine Mehrzahl von elektronischen Vorrichtungen (2) in einer zugehörigen Höhenrichtung befestigt ist, während Seitenräume (S) für eine Verkabelung (4) auf beiden Seiten der elektronischen Vorrichtungen (2) befestigt sind, wobei die Wärmerolladenvorrichtung (5) aufweist:
- einen Wärmerolladen (7), der den Seitenraum (S) für die Verkabelung (4) von der Vorderseite der elektronischen Vorrichtung (2) abdeckt und einen Rückfluss von warmer Luft blockiert, der von einer hinteren Fläche (B) der elektronischen Vorrichtung abgelassen wird und durch die Seitenräume (S) für die Verkabelung (4) hindurchgeht, um zu einer vorderen Fläche (F) der elektronischen Vorrichtung (2) bezüglich jeder elektronischen Vorrichtung zu kriechen;
- eine Verbindungsstange (9), die im Rack (1) in einer Höhenrichtung der elektronischen Vorrichtung über einen Basisbereich (8) vorgesehen ist; und
- einen Eingriffsbereich (10), der auf einer Seite des Wärmerolladens (7) vorgesehen und schwenkbar mit der Verbindungsstange (9) in Eingriff ist.

2. Wärmerolladenvorrichtung (5) gemäß Anspruch 1,
wobei der Wärmerolladen (7) ein elastisches Element (12) aufweist, das einen Zwischenraum zwischen dem Wärmerolladen (7) und der elektronischen Vorrichtung (2) auf einer hinteren Fläche des Wärmerolladens (7) schließt.

3. Wärmerolladenvorrichtung (5) gemäß Anspruch 2, wobei das elastische Element (12) aus einem flammhemmenden Schwamm besteht.

4. Wärmerolladenvorrichtung (5) gemäß Anspruch 1, wobei die Mehrzahl von elektronischen Vorrichtungen (2), die in einer zugehörigen Höhenrichtung befestigt sind, umfasst:
- eine erste elektronische Vorrichtung (2a) mit einem Einlassanschluss auf einer zugehörigen vorderen Fläche und einen Ablassanschluss auf einer zugehörigen hinteren Fläche, und
- eine zweite elektronische Vorrichtung (2b) mit einem Einlassanschluss (13) oder einem Auslassanschluss auf einer zugehörigen Seitenfläche,
- wobei ein Einlasskanal (14) oder ein Ablasskanal, die den Einlassanschluss oder den Auslassanschluss und eine vordere Fläche oder eine hintere Fläche der zweiten elektronischen Vorrichtung (2b), die miteinander in Verbindung stehen, aufweisen, an der zweiten elektronischen Vorrichtung (2b) anstelle des Wärmerolladens (7) befestigt ist.

## Revendications

1. Dispositif obturateur de chaleur (5) prévu dans un bâti (1) dans lequel une pluralité de dispositifs électroniques (2) sont montés dans une direction de hauteur de ceux-ci pendant que des espaces latéraux (S) pour câbles (4) sont fixés des deux côtés des dispositifs électroniques (2), le dispositif obturateur de chaleur (5) comprenant :
un obturateur de chaleur (7) couvrant l'espace latéral (S) pour câble (4) du côté avant du dispositif électronique (2) et bloquant un flux de retour d'air chaud, qui est évacué d'une face arrière (B) du dispositif électronique et passe à travers les espaces latéraux (S) pour câble (4) pour se faufiler vers une face avant (F) du dispositif électronique (2), par rapport à chaque dispositif électronique ;
une barre de couplage (9) prévue dans le bâti (1) dans une direction de hauteur du dispositif électronique via une portion de base (8) ; et
une portion de mise en prise (10) prévue sur un côté de l'obturateur de chaleur (7) et mise en prise de manière pivotante avec la barre de couplage (9).

2. Dispositif obturateur de chaleur (5) selon la revendication 1,
dans lequel l'obturateur de chaleur (7) a un élément élastique (12) fermant un espace entre l'obturateur de chaleur (7) et le dispositif électronique (2) sur une face arrière de l'obturateur de chaleur (7).

3. Dispositif obturateur de chaleur (5) selon la revendication 2, dans lequel l'élément élastique (12) est composé d'une éponge ignifuge.

4. Dispositif obturateur de chaleur (7) selon la revendication 1, dans lequel la pluralité de dispositifs électroniques (2) montés dans une direction de hauteur de ceux-ci comprennent :
- un premier dispositif électronique (2a) ayant un orifice d'admission sur une face avant de celui-ci est un orifice d'évacuation sur une face arrière de celui-ci, et
- un deuxième dispositif électronique (2b) ayant un orifice d'admission (13) ou un orifice d'évacuation sur une face latérale de celui-ci,
dans lequel un conduit d'admission (14) ou un conduit d'évacuation, dont l'orifice d'admission ou l'orifice d'évacuation et une face avant ou une face arrière du deuxième dispositif électronique (2b) sont en communication l'un avec l'autre, est fixé au deuxième dispositif électronique (2b) à la place de l'obturateur de chaleur (7).
